# EUROPÄISCHE PATENTSCHRIFT

(11) **EP 3 011 391 B1**
(45) Veröffentlichungstag und Bekanntmachung des Hinweises auf die Patenterteilung: **18.07.2018**
(21) Anmeldenummer: 13736507.8
(22) Anmeldetag: 20.06.2013
(51) Int. Cl.: G03F 7/00

(54) **STEMPEL MIT EINER STEMPELSTRUKTUR SOWIE VERFAHREN ZU DESSEN HERSTELLUNG**
MOULD WITH A MOULD PATTERN, AND METHOD FOR PRODUCING SAME
MATRICE POURVUE D'UNE STRUCTURE ET PROCÉDÉ POUR LA FABRIQUER

(43) Veröffentlichungstag der Anmeldung: 27.04.2016
(60) Teilanmeldung: 18176710.4
(73) Patentinhaber: Ev Group E. Thallner GmbH, 4782 St. Florian am Inn (AT)
(72) Erfinder: TREIBLMAYR, Dominik, A-4943 Kirchdorf am Inn (AT)
(74) Vertreter: Schneider, Sascha
(86) Internationale Anmeldenummer: PCT/EP2013/062922
(87) Internationale Veröffentlichungsnummer: WO 2014/202145

(56) Entgegenhaltungen:
- EP-A1- 1 840 648
- WO-A1-02/01294
- WO-A1-2011/095217
- JP-A- 2005 203 032
- US-A1- 2003 178 316
- US-A1- 2005 230 882
- US-A1- 2008 061 214
- LIN M W ET AL: "Role of surfactants in adhesion reduction for step and flash imprint lithography", JOURNAL OF MICROLITHOGRAPHY, MICROFABRICATION AND MICROSYSTEMS, SOCIETY OF PHOTO-OPTICAL INSTRUMENTATION ENGINEERS, BELLINGHAM, US, Bd. 7, Nr. 3, 1. Juli 2008 (2008-07-01), Seiten 33005-1, XP002598450, ISSN: 1537-1646, DOI: 10.1117/1.2968269 [gefunden am 2008-08-13]
- NAE YOON LEE ET AL: "A poly(dimethylsiloxane)-coated flexible mold for nanoimprint lithography", 17. Oktober 2007 (2007-10-17), NANOTECHNOLOGY, IOP, BRISTOL, GB, PAGE(S) 415303, XP020119683, ISSN: 0957-4484 Absatz [02.2]; Abbildung 2b
- S. MESKINIS ET AL: "Ion beam synthesis of the diamond like carbon films for nanoimprint lithography applications", THIN SOLID FILMS, Bd. 515, Nr. 2, 1. Oktober 2006 (2006-10-01), Seiten 636-639, XP55094828, ISSN: 0040-6090, DOI: 10.1016/j.tsf.2005.12.223
- XIN J Z ET AL: "Transfer imprint lithography using a soft mold", MICROELECTRONIC ENGINEERING, ELSEVIER PUBLISHERS BV., AMSTERDAM, NL, Bd. 88, Nr. 8, 17. Januar 2011 (2011-01-17), Seiten 2632-2635, XP028098178, ISSN: 0167-9317, DOI: 10.1016/J.MEE.2011.01.062 [gefunden am 2011-01-28]

## Beschreibung

Die Erfindung betrifft ein Verfahren zur Herstellung eines Stempelstrukturen aufweisenden Stempels.

Die Druckschrift US 2003/0178316 A1 offenbart ein Verfahren für das elektrische Mikrokontaktdrucken. Die Nichtpatentschrift "Ion beam synthesis of diamond like carbon films for nanoimpint lithography applications" von S. Meskinis et al. offenbart nicht haftende Schichten für die Nanoimprint-Lithographie. Der Artikel "a poly (dimethylsiloxane)-coated flexible mold for nanoimprint lithography" offenbart eine beschichtende nicht klebende flexible Form und ihre Anwendungen beim Raumtemperatur für die Imprintlithography.

In der Halbleiterindustrie müssen Strukturierungsprozesse an Materialien durchgeführt werden um entsprechende funktionale Elemente erzeugen zu können. Einer der wichtigsten Strukturierungsprozesse der letzten Jahrzehnte ist bis heute noch die Photolithographie.

In den letzten Jahren hat sich allerdings neben der Photolithographie die Imprinttechnologie als neue, alternative Strukturierungstechnologie durchgesetzt, die nicht ausschließlich, aber momentan noch vorwiegend, zur Strukturierung hochsymmetrischer, vor allem repetitiver, Strukturelemente dient. Mit Hilfe der Imprinttechnologie können Oberflächenstrukturen in eine Prägemasse direkt durch einen Stempelprozess erstellt werden. Die dadurch entstehenden Vorteile sind offensichtlich. Man kann auf Chemikalien zur Entwicklung und Ätzung verzichten, die für einen photolithographischen Prozess noch nötig waren. Des Weiteren können heute bereits Strukturgrößen im Nanometerbereich geprägt werden, deren Herstellung mit der gewöhnlichen Photolithographie nur durch äußerst komplizierte und vor allem teure Anlagen denkbar wäre.

In der Imprinttechnologie unterschiedet man zwischen zwei Arten von Stempeln, den Hartstempeln und den Weichstempeln. Jeder Stempelprozess kann theoretisch mit einem Hartstempel oder einem Weichstempel durchgeführt werden. Es gibt aber mehrere technische und finanzielle Gründe, den Hartstempel selbst nur als sogenannten Masterstempel zu verwenden, und aus diesem Masterstempel, wann immer nötig, einen Weichstempel abzuformen, der dann als eigentlicher Strukturstempel verwendet wird. Der Hartstempel ist also ein Negativ des Weichstempels. Der Hartstempel wird nur für die Herstellung mehrerer Weichstempel benötigt. Weichstempel können durch unterschiedliche chemische, physikalische und technische Parameter von Hartstempel unterschieden werden. Denkbar wäre eine Unterscheidung aufgrund des Elastizitätsverhaltens. Weichstempel besitzen ein vorwiegend auf Entropieelastizität, Hartstempel vorwiegend auf Energieelastizität, beruhendes Verformungsverhalten. Des Weiteren können die beiden Stempelarten beispielsweise über ihre Härte unterschieden werden. Die Härte ist der Widerstand, den ein Material einem eindringenden Körper entgegenstellt. Da Hartstempel vorwiegend aus Metallen oder Keramiken bestehen, besitzen sie entsprechend hohe Härtewerte. Es gibt unterschiedliche Möglichkeiten die Härte eines Festkörpers anzugeben. Eine sehr gebräuchliche Methode ist die Angabe der Härte nach Vickers. Ohne auf Einzelheiten einzugehen kann man grob sagen, dass Hartstempel Vickershärten jenseits von 500 HV besitzen werden.

Hartstempel haben zwar den Vorteil, dass sie durch geeignete Prozesse wie Elektronenstrahllithographie oder Laserstrahllithographie aus einem Bauteil eines Materials mit hoher Festigkeit und hoher Steifigkeit direkt gefertigt werden können. Derartige Hartstempel besitzen eine sehr hohe Härte und sind damit mehr oder weniger verschleißfest. Der hohen Festigkeit und Verschleißfestigkeit stehen allerdings vor allem die hohen Kosten gegenüber, die notwendig sind einen Hartstempel zu erzeugen. Selbst wenn der Hartstempel für hunderte von Prägeschritten genutzt werden kann, wird auch er mit der Zeit einen nicht mehr zu vernachlässigende Verschleiß aufweisen. Des Weiteren ist die Entformung des Hartstempels von der Prägemasse technisch schwierig. Hartstempel besitzen einen relativ hohen Biegewiderstand. Sie sind nicht besonders gut verformbar, müssen also im Idealfall in Normalrichtung abgehoben werden. Bei der Entformung der Hartstempel nach dem Prägeprozess kann es dabei regelmäßig zu einer Zerstörung der geprägten Nano- und/oder Mikrostrukturen kommen, da der Hartstempel eine sehr hohe Steifigkeit besitzt und daher die Mikro- und/oder Nanostrukturen der gerade abgeformten Prägemasse zerstören kann. Des Weiteren können Substrate Defekte aufweisen, die in weiterer Folge zur Beschädigung bzw. Zerstörung des Hartstempels führen können. Wird der Hartstempel allerdings nur als Masterstempel verwendet, ist der Abformprozess des Weichstempels aus dem Masterstempel sehr gut kontrollierbar und mit sehr wenig Verschleiß des Masterstempels verbunden.

Weichstempel lassen sich sehr einfach durch Replikationsprozesse aus dem Masterstempel (Hartstempel) fertigen. Der Masterstempel stellt dabei das zum Weichstempel entsprechende Negativ dar. Die Weichstempel werden also auf dem Masterstempel geprägt, danach entformt und dann als Strukturstempel zum Prägen der Stempelstrukturen auf ein Substrat verwendet. Weichstempel lassen sich viel einfacher, schonender und unproblematischer von der Prägemasse entfernen als Hartstempel. Des Weiteren können beliebig viele Weichstempel von einem Masterstempel abgeformt werden. Nachdem ein Weichstempel einen gewissen Verschleiß ausweist, verwirft man den Weichstempel und formt einen neuen Weichstempel aus dem Masterstempel.

Das Problem mit dem heutigen Stand der Technik besteht darin, dass vor allem Weichstempel aufgrund ihres chemischen Aufbaus eine sehr hohe Saugfähigkeit für andere molekulare Verbindungen besitzen. Sie sind also für andere molekulare Verbindungen permeabel, im Gegensatz zu Hartstempeln, die vorwiegend aus Metallen, Keramiken oder Gläsern bestehen. Bei metallischen und keramischen Mikrostrukturen ist eine Aufnahme von molekularen Substanzen in den meisten Fällen ausgeschlossen, dennoch kann es auch bei speziellen Hartstempeln zu einem Aufsaugen der molekularen Substanzen kommen.

Weichstempel absorbieren während des Prägeprozesses mit der Prägemasse häufig einen Teil der Prägemasse. Die Absorption führt zu mehreren unerwünschten Effekten.

Erstens kommt es durch die Aufnahme der Moleküle der Prägemasse zu einer Aufschwellung des Weichstempels. Die Aufschwellung ist vor allem im Bereich der Mikro- und/oder Nanostrukturen an der Oberfläche des Weichstempels problematisch, da bereits geringe Mengen der Moleküle der Prägemasse ausreichen, die Mikro- und/oder Nanostrukturen zu verzerren. Da ein Weichstempel mehrfach verwendet wird, saugt er im Laufe seiner Verwendung immer mehr Prägemassemoleküle auf. Die Aufnahme der Prägemassemoleküle reduziert die Standzeit der Weichstempel entscheidend. Die Schwellung ist entweder direkt mittels unterschiedlicher Sonden wie beispielsweise der Atomic Force Mikroskopie (AFM), der Rasterelektronenmikroskopie (REM) etc. messbar, oder indirekt über Volumen und/oder Gewichtszunahme. Die Messung der Volumen- und/oder Gewichtszunahme erfordert allerdings Messgeräte mit sehr hohen Auflösungen. Denkbar wäre beispielsweise die Messung der Massenzunahme durch mikro- und/oder nanogravimetrische Methoden.

Des Weiteren werden die Prägemassen entweder thermisch oder mittels elektromagnetischer Strahlung gehärtet. Vor allem bei der Härtung durch elektromagnetische Strahlung wirken sich die bereits teilweise in den Stempel eingedrungenen Prägemassemoleküle negativ auf die Belichtungszeit der gesamten Prägemasse aus. Der Grund hierfür liegt in der Aushärtung der in den Weichstempel eingedrungenen Prägemassemoleküle. Die Prägemassemoleküle im Weichstempel werden ausgehärtet, werden damit weniger transparent und reduzieren damit die Intensität der, zur eigentlichen Prägemasse vordringenden, elektromagnetischen Strahlung. Dieses Problem ist für Weichstempel und Hartstempel gleichermaßen von Bedeutung.

Ein drittes Problem stellt die Adhäsion des Weichstempels dar. Weichstempel bestehen vorwiegend aus Polymeren, die eine ähnliche physikalische und/oder chemische Eigenschaft besitzen wie die Prägemasse. Daher kommt es zu einer Adhäsion der Oberfläche des Weichstempels mit der Prägemasse, die sich negativ auf die Entformungseigenschaft des Weichstempels auswirkt.

Aufgabe der vorliegenden Erfindung ist es daher, die Herstellung von Strukturstempeln für die Imprinttechnologie derart zu verbessern, dass die Eigenschaften des Strukturstempels hinsichtlich Dauer der Verwendbarkeit und Qualität der Abformung verbessert werden.

Diese Aufgabe wird mit den Merkmalen der nebengeordneten Ansprüche gelöst. Vorteilhafte Weiterbildungen der Erfindung sind in den Unteransprüchen angegeben. In den Rahmen der Erfindung fallen auch sämtliche Kombinationen aus zumindest zwei von in der Beschreibung, den Ansprüchen und/oder den Figuren angegebenen Merkmalen. Bei angegebenen Wertebereichen sollen auch innerhalb der genannten Grenzen liegende Werte als Grenzwerte offenbart gelten und in beliebiger Kombination beanspruchbar sein.

Die Erfindung handelt von einem Stempel, erfindungsgemäß einem Weichstempel, welcher durch eine erfindungsgemäße Beschichtung der Stempelstruktur eine extrem einfache Entformung des Stempels von der Prägemasse erlaubt, dessen Aufschwellung verhindert und der durch die eigentliche Prägemasse nicht verunreinigt wird. Die Beschichtung ist demnach erfindungsgemäß insbesondere impermeabel gegenüber der Prägemasse. Es ist von besonderem erfindungsgemäßen Vorteil, wenn sich Hydrophilität und Hydrophobizität zwischen Prägemasse und der Beschichtung des erfindungsgemäßem Strukturstempel abwechseln. Ist die Prägemasse hydrophob, so sollte die Beschichtung des erfindungsgemäßen Strukturstempels hydrophil sein und umgekehrt. In ganz besonderen Fällen kann es allerdings von besonderem Vorteil sein, wenn Strukturstempel und Prägemasse beide hydrophob sind. Durch die Möglichkeit, die erfindungsgemäße Beschichtung des Strukturstempels auszuwählen, kann immer ein Material gewählt werden, welches diese geringe Adhäsionseigenschaften in Bezug auf die Prägemasse besitzt. Des Weiteren ist es daher von erfindungsgemäßem Vorteil, wenn die erfindungsgemäße Beschichtung impermeabel für die Moleküle der Prägemasse ist. Des Weiteren ist es von erfindungsgemäßen Vorteil, wenn die erfindungsgemäße Beschichtung möglichst dünn ist, um im Falle einer biegenden Entformung bei der Verwendung eines Weichstempels möglichst nicht zerstört zu werden. Ein weiterer erfindungsgemäßer Vorteil ist die, insbesondere gezielt einstellbare, Oberfläche der Beschichtung. Dadurch wird es erfindungsgemäß ermöglicht, eine extrem ebene und glatte Kontaktfläche zur Prägemasse herzustellen. Ohne die erfindungsgemäßen Beschichtung würde die Prägemasse während des Prägevorgangs direkt mit der Oberfläche des Stempels in Berührung kommen. Vor allem bei einem Weichstempel, dessen Oberfläche extrem hohe Rauigkeiten aufweist, würde sich das negativ auf die zu prägende Struktur auswirken. Durch die Verwendung einer erfindungsgemäßen Beschichtung wird erstens durch eine glattere Oberfläche die Kontaktfläche zur Prägemasse minimiert und zweitens eine formschlüssige Verbindung der Oberflächen weitgehend vermieden. Dadurch kommt es zu einer besseren Entformung. Die bessere und effizientere Entformung ist vor allem darauf zurück zu führen, dass die notwendige Kraft zur Entformung geringer wird. Die Rauigkeit der Oberfläche der erfindungsgemäßen Beschichtung ist daher insbesondere kleiner als 1µm, mit Vorzug kleiner als 100nm, mit größerem Vorzug kleiner als 10nm, mit größtem Vorzug kleiner als 1nm. Die offenbarten Rauheitswerte gelten für die mittlere Rauheit und/oder die quadratische Rauheit und/oder die gemittelte Rautiefe.

In einer ganz besonderen Ausführungsform ist die erfindungsgemäße Beschichtung elektrisch leitfähig. Dadurch wird mit Vorzug die elektrostatische Aufladung verhindert oder zumindest vermindert. Noch bevorzugter kann die elektrisch leitfähige, erfindungsgemäße Beschichtung geerdet ausgeführt sein, sodass eine an ihrer Oberfläche entstehende elektrische Aufladung abgeführt wird. Durch die elektrisch neutrale Oberfläche wird die Anziehung, im Besonderen die elektrostatische Anziehung, von Partikeln erschwert bzw. vollständig eliminiert und erhöht damit die Sauberkeit des Stempels über längere Zeit. Die Erdung kontaktiert die erfindungsgemäße Beschichtung mit Vorzug am Rand.

Unter Hydrophilität versteht man die hohe Wechselwirkungsfähigkeit der Oberfläche eines Stoffes mit Wasser. Hydrophile Oberflächen sind vorwiegend polar und interagieren mit den permanenten Dipolen der Moleküle von Fluiden, bevorzugt mit Wasser, entsprechend gut. Die Hydrophilität einer Oberfläche wird mit Hilfe eines Kontaktwinkelmessgeräts quantifiziert. Hydrophile Oberflächen besitzen dabei sehr geringe Kontaktwinkel. Muss die erfindungsgemäße Beschichtung eine hydrophile Oberfläche besitzen, um möglichst einfach von der Prägemasse entformt werden zu können, dann sollen erfindungsgemäß folgende Wertebereiche gelten: Eine erfindungsgemäße hydrophile Oberfläche besitzt insbesondere einen Kontaktwinkel kleiner als 90°, mit Vorzug kleiner als 60°, mit größerem Vorzug kleiner als 40°, mit noch größerem Vorzug kleiner als 20°, mit allergrößtem Vorzug von weniger als 1°.

Unter Hydrophobie versteht man entsprechend die geringe Wechselwirkungsfähigkeit der Oberfläche eines Stoffes mit Wasser. Hydrophobe Oberflächen sind vorwiegend unpolar und interagieren kaum mit den permanenten Dipolen der Moleküle von Fluiden. Weist die erfindungsgemäße Beschichtung in einer Ausführungsform der Erfindung eine hydrophobe Oberfläche auf, um möglichst einfach von der Prägemasse entfernt werden zu können, dann sollen erfindungsgemäß folgende Wertebereiche gelten: Eine erfindungsgemäße hydrophobe Oberfläche besitzt insbesondere einen Kontaktwinkel größer als 90°, mit Vorzug größer als 100°, mit größerem Vorzug größer als 120°, mit noch größerem Vorzug größer als 140°, mit allergrößtem Vorzug größer als 160°.

Der erfindungsgemäße Stempel ist ein Imprintstempel zur Verwendung in der Imprinttechnologie. Der Stempel ist als Weichstempel zum Imprinten von Substraten ausgebildet.

Durch die erfindungsgemäße Beschichtung wird die Entformung des Stempels von der Prägemasse ohne Beeinträchtigung und/oder (teilweiser) Zerstörung der Strukturen ermöglicht, indem die Beschichtung bevorzugt eine geringe Adhäsion gegenüber der Prägemasse hat. Die Adhäsionsfähigkeit zwischen zwei Oberflächen lässt sich am besten durch eine Energie pro Einheitsfläche, also eine Energieflächendichte, beschreiben. Darunter versteht man die Energie die notwendig ist, um zwei miteinander verbundene Oberflächen entlang der Einheitsfläche wieder voneinander zu trennen. Die erfindungsgemäße Adhäsion zwischen Prägemasse und Strukturstempel ist dabei insbesondere kleiner als 2.5 J/m², mit Vorzug kleiner als 1 J/m², mit größerem Vorzug kleiner als 0.1 J/m², mit noch größerem Vorzug kleiner als 0.01 J/m², mit größtem Vorzug kleiner als 0.001 J/m², mit allergrößtem Vorzug kleiner als 0.0001 J/m², am bevorzugtesten kleiner als 0.00001 J/m². Die Entformung ist dadurch leichter, schneller, effizienter und kostengünstiger möglich als mit einem Stempel ohne Beschichtung oder einem Hartstempel. Kostengünstiger ist sie vor allem dadurch, dass durch die erhöhte Entformungsgeschwindigkeit die Anzahl der Prägeschritte pro Zeiteinheit erhöht werden kann. Außerdem wird die Standzeit des Stempels drastisch erhöht, so dass auch hierdurch die Herstellungskosten reduziert werden.

Weiterhin wird durch die Dichtigkeit der Beschichtung ein Aufschwellen des Strukturstempels, insbesondere des Weichstempels, durch die Beschichtung verhindert, da keine Prägemasse in den Weichstempel eindringen kann. Entsprechend wird eine Verzerrung der Stempelstruktur weitestgehend vermieden.

Weiterhin wird die Belichtungszeit der Prägemasse durch die Beschichtung des Stempels reduziert werden, soweit die Aufnahme von Prägematerial in die Stempelstrukturen durch die Beschichtung blockiert wird. Dies ist vor allem erfindungsgemäß vorteilhaft, soweit die Prägemasse durch den Strukturstempel belichtet wird. Die erfindungsgemäße Beschichtung ist damit mit Vorzug überwiegend transparent für die verwendete elektromagnetische Strahlung. Da die meisten Prägemassen mit UV Licht gehärtet werden, ist die erfindungsgemäße Beschichtung mit Vorzug transparent für UV Licht. Die erfindungsgemäße Beschichtung ist daher insbesondere transparent in einem Wellenlängenbereich zwischen 5000nm und 10nm, mit Vorzug zwischen 1000nm und 100nm, mit größerem Vorzug zwischen 700nm und 200nm, mit größtem Vorzug zwischen 500nm und 400nm.

Mit Vorzug wird, insbesondere zusätzlich zu der Beschichtung, eine Stempeloberfläche mit einer niedrigen Adhäsionseigenschaft zur Prägemasse ausgebildet.

Der Erfindung liegt gemäß einem weiteren Aspekt der Erfindung der Gedanke zu Grunde, die Oberfläche des Stempels, mit Vorzug ein Weichstempel, mit einer Schicht, mit Vorzug einer Metallschicht, durch einen erfindungsgemäßen Beschichtungsprozess zu beschichten.

Die Stempelstrukturen und/oder der Strukturstempel selbst bestehen insbesondere zumindest überwiegend, vorzugsweise vollständig, aus mindestens einem der folgenden Materialien:
- Polymere, insbesondere
   ∘ Polydimethylsiloxan (PDMS)
   ∘ Perfluoropolyether (PFPE)
   ∘ Polyhedrales oligomerisches Silsesquioxan (POSS)
   ∘ Polydimethylsiloxan (PDMS)

Bevorzugt bestehen die Stempelstrukturen im Falle der erfindungsgemäßen Weichstempel aus Polydimethylsiloxan (PDMS). Des Weiteren ist es erfindungsgemäß denkbar, den Stempel, insbesondere die Stempelstrukturen, aus einer Materialkombination der oben genannten Materialien herzustellen. Denkbar ist auch die Verwendung eines Stempels und einer Rückplatte (engl.: backplane) in Serie, wobei Stempel und Rückplatte insbesondere aus unterschiedlichen Materialien bestehen. Die Verwendung mehrerer unterschiedlicher Materialien führt dazu, dass die daraus hergestellten einzelnen oder zusammengesetzten Stempel als erfindungsgemäß vorteilhafte Hybridstempel bezeichnet werden. Die Rückplatte kann dabei als Versteifung des Stempels dienen. Denkbar sind allerdings auch Rückplatten die extrem flexible sind und nur als Träger für den Stempel dienen. Die Rückplatte hat dann insbesondere eine Dicke, die geringer ist als 2000µm, mit Vorzug geringer als 1000µm, mit größerem Vorzug geringer als 500µm, mit größtem Vorzug geringer als 100µm.

Die erfindungsgemäße Beschichtung ist allerdings vor allem dann besonders wirksam, wenn der Strukturstempel oder zumindest das Material der Stempelstrukturen zumindest teilweise aus einem Material besteht, welches die Prägemasse aufsaugen kann. Entsprechend werden die Stempelstrukturen folgender Materialien durch die erfindungsgemäße Beschichtung besonders geschützt:
- Polydimethylsiloxan (PDMS)
- Polymere
- Perfluoropolyether (PFPE)

Der erfindungsgemäße Beschichtungsprozess ist vorzugsweise einer der folgenden:
- Chemical Vapour Deposition (CVD)
- Physical Vapour Deposition (PVD)
- PE-CVD
- Elektrochemische Abscheidung
- Atomic Layer Deposition (ALD)
- Molecule Layer Deposition (MLD).

Erfindungsgemäß bevorzugt ist das CVD Verfahren, insbesondere zur Abscheidung von Chrom.

Als Beschichtungsmaterial zur zumindest teilweisen Beschichtung der Stempelstrukturen werden erfindungsgemäß vor allem folgende Materialien/Materialklassen verwendet:
- Metalle
   ∘ Cr, Be, Wi, Cd, Ga, In, Ir, Mg, Mn, Mo, Os, Pa, Rh, Ru, Ta, Ti, V, Zn, Sn, Zr, Cu, Ni, Co, Fe, Pt, Ag, Au, Pb, W, Al
- Halbleitermaterialien
   ∘ Si, Ge, α-Sn, Se, Te, B, GaP, GaAs, InP, InSb, InAs, GaSb, GaN, AlN, InN, AlxGal-xAs, InxGal-xN bzw. Oxide der genannten Materialien
- Keramiken
   ∘ Nicht-Oxidkeramiken (Karbide, Nitride, Boride, Silicide)
   ∘ Si3N4, BN, SiC
- Oxidkeramiken
   ∘ Al2O3, MgO, ZrO2, TiO, Ti2O3, TiO2
   ∘ Suboxide
- Gläser
   ∘ Borosilikatglas, Quarz (SiO2).

Bevorzugt werden für die erfindungsgemäße Beschichtung solche Materialien ausgewählt, die eine niedrige Adhäsion zur Prägemasse aufweisen, insbesondere folgende Materialen:
- Metalle, insbesondere
   ∘ Cr, Be, Wi, Cd, Ga, In, Ir, Mg, Mn, Mo, Os, Pa, Rh, Ru, Ta, Ti, V, Zn, Sn, Zr, Cu, Ni, Co, Fe, Pt, Ag, Au, Pb, W, Al.

In einer besonders bevorzugten Ausführungsform wird der Stempel zuerst mit dem erfindungsgemäßen Beschichtungsmaterial beschichtet und danach zusätzlich mit einer Antihaftschicht, um zusätzlich eine Verringerung der Adhäsion zwischen Beschichtungsmaterial und Prägemasse zu erreichen. Mit Vorzug handelt es sich bei der Antihaftschicht um organische Moleküle mit entsprechend niedrigen Adhäsionseigenschaften zur Prägemasse. Stempel, die bereits impermeabel für die Moleküle der Prägemasse sind, und die nicht Gegenstand dieser Erfindung sind,
so wie es beispielsweise für metallische, keramische oder gläserne Stempel meist der Fall ist, können auf eine erfindungsgemäße Beschichtung als Diffusionsbarriere verzichten, und der Stempel kann direkt mit einer Antihaftschicht beschichtet werden. Damit ergibt sich ein positiver Effekt bezüglich der Entformungseigenschaft auf Grund von Adhäsion. Gemäß einer weiteren, vorteilhaften Ausführungsform der Erfindung werden nur die Stempelflächen der Strukturen des Stempels, also insbesondere Erhebungen der Stempelstrukturen, die mit einer

Prägemasse in Kontakt kommen, beschichtet. Das kann vor allem für das Nanokontaktimprinting von Interesse sein.

In einer besonderen Ausführungsform wird die gesamte Oberfläche der Stempelstrukturen des Stempels mit der erfindungsgemäßen Beschichtung beschichtet.

Die Schichtdicke der erfindungsgemäßen Beschichtung ist insbesondere kleiner als 1mm, mit Vorzug kleiner als 100µm, mit größerem Vorzug kleiner als 10µm, mit größtem Vorzug kleiner als 1µm, mit allergrößtem Vorzug kleiner als 100nm, am bevorzugtesten kleiner als 10nm.

Die extrem geringen Schichtdicken haben auch einen positiven Effekt auf die Transparenz der verwendeten elektromagnetischen Strahlung. Ein Festkörper kann nur Photonen absorbieren, die mit einem Teilchen (bsp.: Elektron) oder einem Quasiteilchen (insbesondere optisches Phonon) im Festkörper wechselwirken. Diese Effekte sind jedem Physiker hinlänglich bekannt. Nun können diese Wechselwirkungen zwar nicht umgangen werden, es ist allerdings möglich, die Anzahl der Photonen durch die Intensität der elektromagnetischen Strahlung so zu erhöhen, bzw. die Anzahl der Teilchen (bzw. Quasiteilchen) im Festkörper durch die erfindungsgemäße Verringerung der Schichtdicke so zu reduzieren, dass erstere, also die Photonen die zweiten, also die Teilchen und Quasiteilchen, überwiegen. Damit kommt der Festkörper mit der Anregung der Teilchen (bzw. Quasiteilchen) nicht mehr mit und die Photonen werden erfindungsgemäß durch die Verringerung der Schichtdicke der Beschichtung in dir Lage versetzt, den eigentlich intransparenten Festkörper zu durchdringen. Der Festkörper wird durch die Schichtdicke zumindest teilweise transparent. Es wird daher offenbart, dass die geringe Dicke der erfindungsgemäßen Beschichtung einen positiven Effekt auf die Menge der die Beschichtung durchdringenden Photonen hat. Dies wiederum wirkt sich positiv auf die Aushärtung der von der Beschichtung bedeckten Prägemasse aus.

Das erfindungsgemäße Beschichtungsmaterial ist bei UV-Aushärtung des Prägematerials mit Vorzug zumindest teilweise transparent für den Wellenlängenbereich der elektromagnetischen Strahlung, welche das Prägematerial vernetzt. Die optische Transparenz ist dabei größer als 0%, mit Vorzug größer als 20%, mit größerem Vorzug größer als 50%, mit größtem Vorzug größer als 80%, mit allergrößtem Vorzug größer als 95%. Der Wellenlängenbereich für die optische Transparenz liegt insbesondere zwischen 100nm und 1000nm, vorzugsweise zwischen 150nm und 500nm, mit größerem Vorzug zwischen 200nm und 400nm, mit größtem Vorzug zwischen 250nm und 350nm.

Ist die Prägemasse thermisch auszuhärten, besitzt der Stempel, insbesondere die erfindungsgemäße Beschichtung, eine möglichst hohe Wärmeleitfähigkeit. Die Wärmeleitfähigkeit ist dabei größer als 0.1 W/(m*K), mit Vorzug größer als 1 W/(m*K), mit Vorzug größer als 10 W/(m*K), mit größtem Vorzug größer als 100 W/(m*K), mit allergrößtem Vorzug größer als 1000 W/(m*K).

Der Strukturstempel mit Beschichtung ist insbesondere temperaturstabil ausgebildet. Der Strukturstempel kann insbesondere bei Temperaturen größer 25°C, mit Vorzug größer 100°C, mit größerem Vorzug größer als 500°C, mit größtem Vorzug größer als 1000°C, mit allergrößtem Vorzug größer als 1500°C verwendet werden.

Das Verhältnis zwischen dem thermischen Ausdehnungskoeffizienten des Beschichtungsmaterials und dem thermischen Ausdehnungskoeffizienten des Stempelmaterials ist kleiner als 10000, mit Vorzug kleiner als 1000, mit größerem Vorzug kleiner als 100, mit noch größerem Vorzug kleiner als 10, mit größtem Vorzug kleiner als 5, mit allergrößtem Vorzug genau 1.

Weitere Merkmale der Erfindung ergeben sich aus den Patentansprüchen, der nachfolgenden Figurenbeschreibung sowie der Zeichnung. Diese zeigt in:
- Figur 1: eine schematische Querschnittsdarstellung eines Stempels in einem ersten erfindungsgemäßen Herstellungsschritt,
- Figur 2: eine schematische Querschnittsdarstellung eines Stempels in eine zweiten erfindungsgemäßen Herstellungsschritt und
- Figur 3: eine schematische Querschnittsdarstellung eines Stempels in einem dritten erfindungsgemäßen Herstellungsschritt.

In den weiteren Ausführungen wird die Herstellung eines mit einer Erdung 4 versehenen, mit einer erfindungsgemäßen Schicht 5 beschichteten, Stempels 1 offenbart.

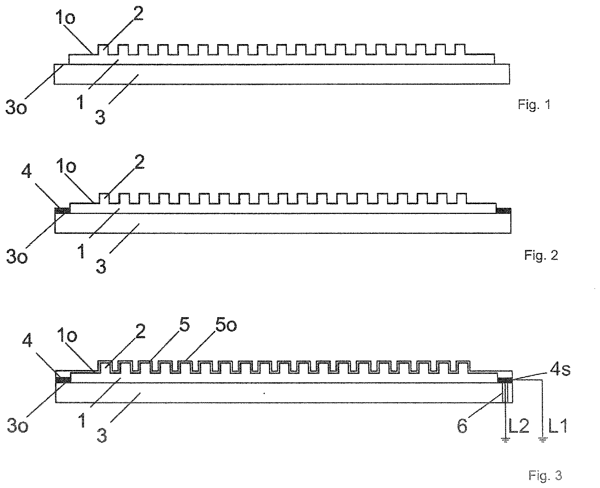

In einem ersten Herstellungsschritt gemäß Figur 1 wird ein Stempel 1 mit einer Stempeloberfläche 1o und Strukturen 2 auf einer Rückplatte 3 befestigt.

In einem zweiten Herstellungsschritt gemäß Figur 2 wird eine, insbesondere ringförmige, vorzugsweise ausschließlich am seitlichen Umfangsrand angeordnete, Abscheidung einer elektrisch leitfähigen Schicht, einer Erdung 4, seitlich des Stempels 1, an der Rückplattenoberfläche 3o der Rückplatte 3 durchgeführt.

In einem dritten Herstellungsschritt gemäß Figur 3 erfolgt die Beschichtung des Stempels 1 mit einer erfindungsgemäßen Beschichtung 5 in der Art, dass die Beschichtung 5 auch die Erdung 4 kontaktiert, insbesondere zumindest überwiegend, vorzugsweise vollständig, bedeckt und somit einen leitenden Kontakt zwischen der Beschichtungsoberfläche 5o und der Erdung 4 herstellt.

Die Erdung 4 umschließt den Stempel 2 mit Vorzug vollständig. Die elektrische Ladung kann beispielsweise an der Seite 4s der Erdung 4 über eine Leitung L1 abgenommen werden. Alternativ oder zusätzlich denkbar wäre auch die Herstellung einer Bohrung 6 durch die Rückplatte 3, um die Ladung über eine Leitung L2 abzunehmen.

Kann auf eine Rückplatte 3 verzichtet werden, ist es insbesondere denkbar, die Erdung 4 direkt am Rand des Stempels 1 abzuscheiden.

### Bezugszeichenliste

- 1: Stempel
- 1o: Stempeloberfläche
- 2: Strukturen
- 3: Rückplatte
- 3o: Rückplattenoberfläche
- 4: Erdung
- 5: Beschichtung
- 5o: Beschichtungsoberfläche
- 6: Bohrung
- L1, L2: Leitungen

## Patentansprüche

1. Verfahren zur Herstellung eines Stempelstrukturen aufweisenden Imprintstempels zum Prägen von Mikro- und/oder Nanostrukturen in eine Prägemasse, wobei der Imprintstempel ein Weichstempel ist und durch Biegung des Weichstempels von der Prägemasse entformbar ist, wobei die Stempelstrukturen mit einer Beschichtung beschichtet werden, wobei die Beschichtung transparent für UV Licht für die Aushärtung des Prägematerials ist, wobei als Beschichtungsmaterial zur Beschichtung der Stempelstrukturen mindestens eines der folgenden Materialien/Materialklassen verwendet wird:
• Metalle
• Halbleitermaterialien
• Keramiken
• Gläser.

2. Verfahren nach Anspruch 1, wobei die Stempelstrukturen und/oder der Weichstempel, insbesondere zumindest überwiegend, vorzugsweise vollständig, aus mindestens einem der folgenden Materialien gebildet ist/sind:
• Polydimethylsiloxan (PDMS)
• Perfluoropolyether (PFPE)
• Polyhedrales oligomerisches Silsesquioxan (POSS)

3. Verfahren nach einem der Ansprüche 1 oder 2, wobei die Beschichtung durch mindestens eines der nachfolgend angegebenen Verfahren aufgebracht wird:
• Chemical Vapour Deposition (CVD)
• Physical Vapour Deposition (PVD)
• PE-CVD
• Elektrochemische Abscheidung
• Atome Layer Deposition (ALD)
• Molecule Layer Deposition (MLD).

4. Imprintstempel mit einer Stempelstruktur zum Prägen von Nanostrukturen in eine Prägemasse, wobei die Stempelstruktur zumindest teilweise mit einer Beschichtung beschichtet ist, hergestellt mit einem Verfahren nach einem der vorhergehenden Ansprüche.

5. Imprintstempel nach Anspruch 4, wobei die Stempelstruktur aus Poly-Dimethyl-Siloxan (PDMS) oder Perfluoropolyether (PFPE) besteht.

## Claims

1. Method for the production of a structural die that has die structures for applying microstructures and/or nanostructures in an embossing material, whereby the die is a soft die and can be deformed from the embossing material by bending the soft die, wherein the die structures are coated with a coating, wherein the coating is transparent for UV-light for hardening the embossing material, whereby as coating material for coating the die structures, at least one of the following materials/material classes is used:
• Metals
• Semiconductor Materials
• Ceramics
• Glass.

2. Method according to Claim 1, whereby the die structure and/or the soft die, in particular at least predominantly, preferably completely, is/are formed from at least one of the following materials:
• Polydimethylsiloxane (PDMS)
• Perfluoropolyether (PFPE)
• Polyhedral oligomeric silsesquioxane (POSS).

3. Method according to one of Claims 1 or 2, whereby the coating is applied by at least one of the methods indicated below:
• Chemical Vapor Deposition (CVD)
• Physical Vapor Deposition (PVD)
• PE-CVD
• Electrochemical Deposition
• Atomic Layer Deposition (ALD)
• Molecule Layer Deposition (MLD).

4. Imprint die with a die structure for applying nanostructures in an embossing material, whereby the die structure is coated at least partially with a coating, produced with a method according to one of the proceedings claims.

5. Die according to Claim 4, whereby the die structure consists of polydimethylsiloxane (PDMS) or Perfluoropolyether (PFPE).

## Revendications

1. Procédé destiné à la fabrication d'un tampon d'impression présentant des structures de tampon pour marquer des microstructures et/ou des nanostructures dans une masse de matriçage, dans lequel le tampon d'impression est un tampon souple et démoulable de la masse de matriçage par flexion du tampon souple, dans lequel les structures de tampon sont revêtues d'un revêtement, dans lequel le revêtement est transparent à la lumière UV pour durcir le matériau de matriçage, dans lequel, comme matériau de revêtement pour revêtir les structures de tampon, on emploie au moins un des matériaux/une des classes de matériaux suivant(e)s :
• métaux,
• matériaux pour semi-conducteurs,
• céramiques,
• verres.

2. Procédé selon la revendication 1, dans lequel les structures de tampon et/ou le tampon souple, en particulier au moins en majeure partie, de préférence complètement, est/sont composé(s) d'au moins un des matériaux suivants :
• polydiméthylsiloxane (PDMS)
• perfluoropolyéther (PFPE)
• silsesquioxane oligomère polyédrique (POSS).

3. Procédé selon la revendication 1 ou 2, dans lequel le revêtement est appliqué par au moins un des procédés suivants :
• dépôt chimique en phase vapeur (CVD)
• dépôt physique en phase vapeur (PVD)
• PE-CVD
• séparation électrochimique
• dépôt par couche atomique (ALD)
• dépôt par couche moléculaire (MLD).

4. Tampon d'impression comprenant une structure de tampon pour marquer des nanostructures dans une masse de matriçage, dans lequel la structure de tampon est revêtue au moins partiellement d'un revêtement, fabriqué par un procédé selon l'une des revendications précédentes.

5. Tampon d'impression selon la revendication 4, dans lequel la structure de tampon est en poly-diméthyl-siloxane (PDMS) ou perfluoropolyéther (PFPE).
